# EUROPEAN PATENT APPLICATION

(11) **EP 4 654 131 A1**
(43) Date of publication of application: **26.11.2025**
(21) Application number: 23917682.9
(22) Date of filing: 08.12.2023
(51) Int. Cl.: G06T 7/80, G06V 10/44, G16Y 40/20

(54) **SETTING PROGRAM, SETTING METHOD, AND INFORMATION PROCESSING DEVICE**

(30) Priority: 16.01.2023 JP 2023004640
(71) Applicant: FUJITSU LIMITED, Kawasaki-shi, Kanagawa 211-8588 (JP)
(72) Inventor: MOTEKI, Atsunori, Kawasaki-shi, Kanagawa 211-8588 (JP); HIRAI, Yukio, Kawasaki-shi, Kanagawa 211-8588 (JP); SUZUKI, Genta, Kawasaki-shi, Kanagawa 211-8588 (JP)
(74) Representative: Hoffmann Eitle
(86) International application number: PCT/JP2023/043959
(87) International publication number: WO 2024/154471

(57) **Abstract**

To improve accuracy of camera parameters, an information processing device acquires a two-dimensional video in which an object is arranged in a physical space, the two-dimensional video being captured by a camera device, acquires three-dimensional design data defining formation of the object in a virtual space, displays, on a screen, in a selectable state, first edge lines of the object extracted from a captured image included in the two-dimensional video and second edge lines of the object in the three-dimensional design data, receives a selection instruction indicating a pair of the first edge line and the second edge line that are targets to be superimposed, and sets camera parameters of the camera device based on superimposition operation for the pair of the first edge line and the second edge line.

## Description

### Technical Field

The present invention relates to a camera parameter setting program and the like.

### Background Art

As a technology for expressing, in a virtual space, an object present in a physical space of the real world, there is a technology called a digital twin. For example, in the digital twin, by utilizing the Internet of Things (IoT) or the like, data is collected in real time from a production line, equipment, or the like of a factory that is actually moving, and various simulations are executed. By repeatedly executing processing of notifying simulation results in the virtual space to a site and feeding back situations of the site to the virtual space, it is possible to improve production efficiency and prevent accidents and the like that may occur in advance.

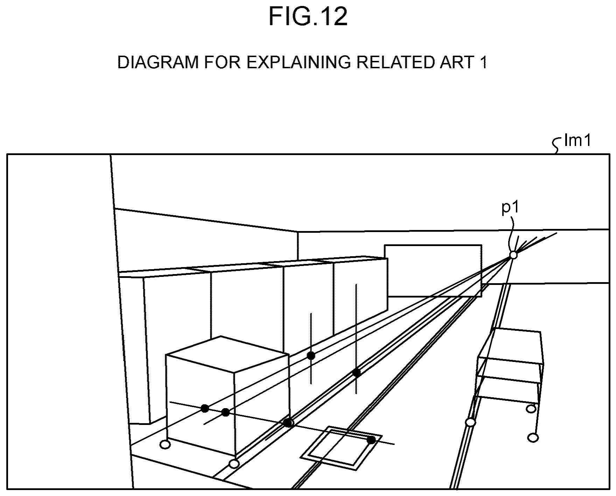

Here, in order to express, in the virtual space, an object present in the physical space, parameters of a camera that captures an image of the physical space are used. In the following explanation, the parameters of the camera is referred to as "camera parameters". As a technique for estimating the camera parameters, there is related art 1 explained with reference to FIG. 12.

FIG. 12 is a diagram for explaining the related art 1. As illustrated in FIG. 12, in the related art 1, by analyzing an image Im1 captured by a monocular camera, a plurality of feature lines is detected from an object on an environment, and a vanishing point p1 is specified. In the related art 1, the camera parameters are estimated based on the vanishing point p1.

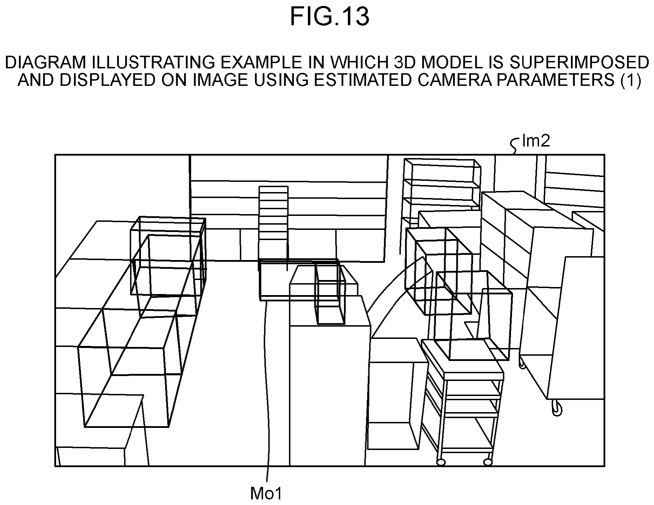

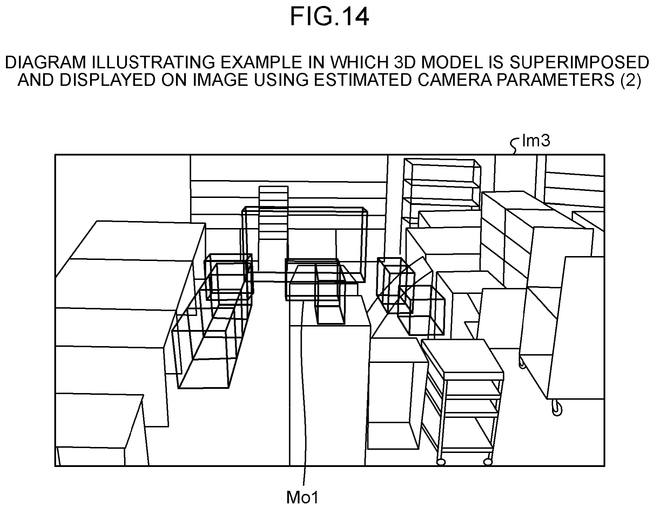

FIG. 13 and FIG. 14 are diagrams illustrating an example in which a 3D model is superimposed and displayed on an image using estimated camera parameters. For example, the 3D model is generated based on Computer-Aided Design (CAD) data. For example, when the camera parameters are correct values, as illustrated in an image Im2 of FIG. 13, main ridge lines of a 3D model Mo1 and main edges of the object on the environment coincide.

On the other hand, when the camera parameters are not a correct values, as illustrated in an image Im3 of FIG. 14, main ridge lines of the 3D model Mo1 and unnecessary edges of the object in the environment do not coincide.

As illustrated in FIG. 14, when the main ridge lines of the 3D model Mo1 and the unnecessary edges of the object on the environment do not coincide, a user manually adjusts the camera parameters. In related art 2, by adjusting a part of the camera parameters such that the main ridge lines of the 3D model Mo1 and the unnecessary edges of the object on the environment coincide, final camera parameters are specified.

### Citation List

### Patent Literature

Patent Literature 1: Japanese Laid-open Patent Publication No. 2022-161342

### Summary of invention

### Technical Problem

In the related art 1 explained above, since the feature line is extracted not from the known reference object but from the object on the environment, there is a case in which the accuracy of the camera parameters is deteriorated due to the influence of the complexity of the site. In the related art 2 explained above, a part of the camera parameters is adjusted. However, when adjustment targets increase, it is difficult to match the main ridge lines of the 3D model and unnecessary edges of the object on the environment, and it is difficult to appropriately set by the camera parameters.

In one aspect, an object is to provide a setting program, a setting method, and an information processing device that can improve accuracy of camera parameters.

### Solution to Problem

The first idea involves having a computer execute the following processes. The computer executes acquiring a two-dimensional video in which an object is arranged in a physical space, the two-dimensional video being captured by a camera device. The computer executes acquiring three-dimensional design data defining formation of the object in a virtual space. The computer executes displaying, on a screen, in a selectable state, first edge lines of the object extracted from a captured image included in the two-dimensional video and second edge lines of the object in the three-dimensional design data. The computer executes receiving a selection instruction indicating a pair of the first edge line and the second edge line that are targets to be superimposed. The computer executes setting camera parameters of the camera device based on superimposition operation for the pair of the first edge line and the second edge line.

### Advantageous Effects of Invention

It is possible to improve accuracy of the camera parameters.

### Brief Description of Drawings

FIG. 1 is a diagram illustrating a system according to an embodiment.
FIG. 2 is a flowchart illustrating a processing procedure of an information processing device according to the embodiment.
FIG. 3 is a diagram illustrating an example of a three-dimensional CAD model.
FIG. 4 is a diagram for explaining an example of alignment processing executed by the information processing device.
FIG. 5 is a diagram illustrating an example of a process of calibration.
FIG. 6 is a functional block diagram illustrating a configuration of the information processing device according to the embodiment.
FIG. 7 is a diagram illustrating an example of a data structure of CAD data.
FIG. 8 is a view for explaining an example of a human body model.
FIG. 9 is a diagram illustrating an example of joint names.
FIG. 10 is a diagram for explaining processing of an alignment processing unit.
FIG. 11 is a diagram illustrating an example of a hardware configuration of a computer that implements the same functions as the functions of the information processing device according to the embodiment.
FIG. 12 is a diagram for explaining the related art 1.
FIG. 13 is a diagram (1) illustrating an example in which a 3D model is superimposed and displayed on an image using estimated camera parameters.
FIG. 14 is a diagram (2) illustrating an example in which a 3D model is superimposed and displayed on an image using estimated camera parameters.

### Embodiments for Carrying Out the Invention

Hereinafter, an embodiment of a design program, a setting method, and an information processing device disclosed in the present application is explained in detail with reference to the drawings. Note that the present invention is not limited by the embodiment.

### Embodiment

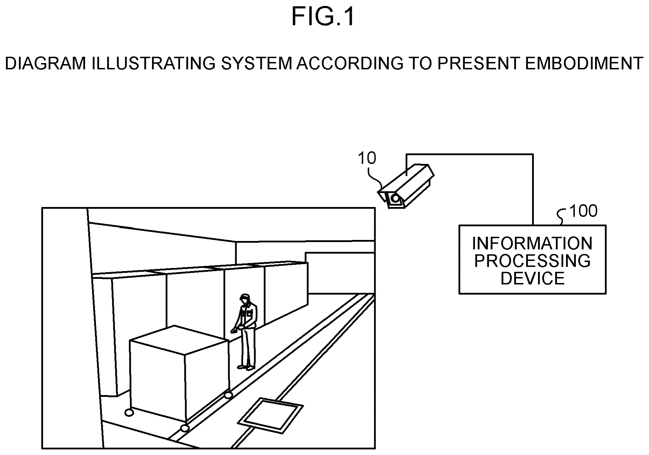

A system according to the present embodiment is explained. FIG. 1 is a diagram illustrating a system according to the present embodiment. For example, the system in the present embodiment includes a camera 10 and an information processing device 100. The camera 10 and the information processing device 100 are connected to each other via a network. Although only the camera 10 is illustrated in FIG. 1, the system according to the present embodiment may further include other cameras.

The camera 10 is installed at a predetermined position in a factory. For example, various kinds of equipment are installed in the factory. The camera 10 captures an image (a video) of the inside of the factory and transmits data of the captured image to the information processing device 100. In the following explanation, the data of the image is referred to as "image data". Camera identification information for identifying the camera 10 that has captured the image data is added to the image data. In the following explanation, image data is used, but data of a video may be used. The data of the video is information including time-series image data.

The information processing device 100 generates "setting information" for expressing, in a virtual space, an object present in a physical space such as a factory by executing the following processing using the digital twin technology.

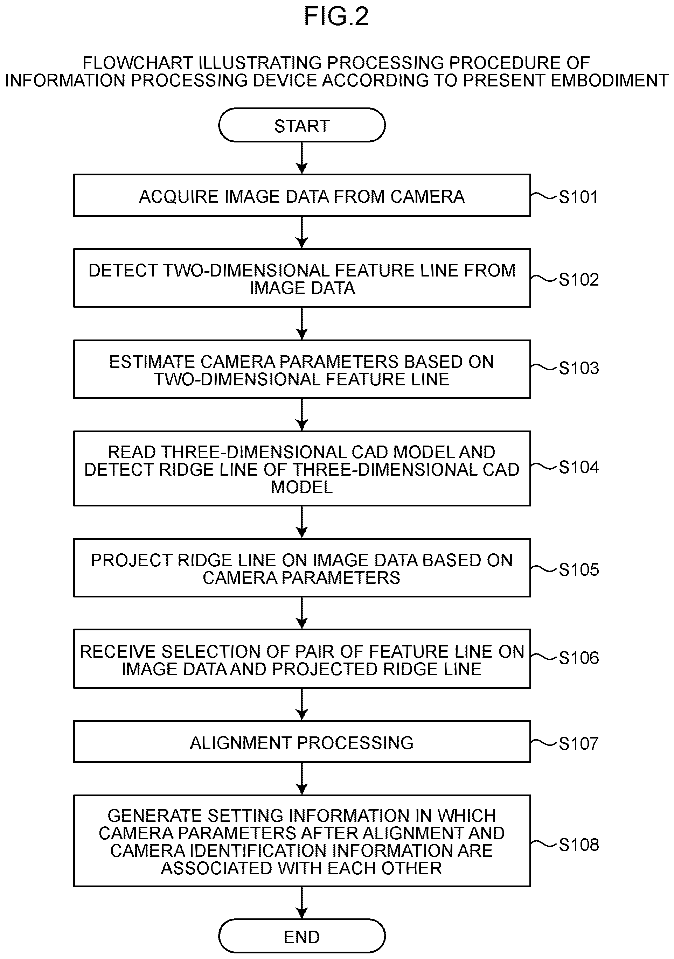

FIG. 2 is a flowchart illustrating a processing procedure of the information processing device according to the present embodiment. As illustrated in FIG. 2, the information processing device 100 acquires image data from the camera 10 (Step S101). The information processing device 100 extracts a two-dimensional feature line from the image data (Step S102).

The information processing device 100 estimates camera parameters based on the two-dimensional feature line (Step S103). The camera parameters correspond to internal parameters and external parameters. For example, the camera parameters include a focal length f, a rotation R (a rotation matrix R), and a translation T (a translation vector T).

The information processing device 100 reads a three-dimensional CAD model and detects a ridge line of the three-dimensional CAD model (Step S104). The information processing device 100 projects the ridge line on the image data based on the camera parameters (Step S105).

The information processing device 100 receives selection of a pair of the feature line on the image data and the projected ridge line (Step S106). The information processing device 100 executes alignment processing (Step S107). The information processing device 100 generates setting information in which the camera parameters after the alignment and the camera identification information are associated with each other (Step S108).

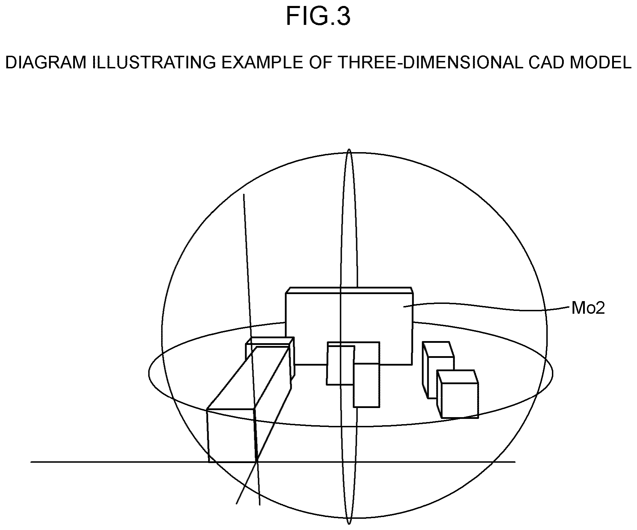

An example of the three-dimensional CAD model read in Step S104 in FIG. 2 is illustrated in FIG. 3. FIG. 3 is a diagram illustrating an example of the three-dimensional CAD model. The three-dimensional CAD model Mo2 is information defining formation of an object in the virtual space. In the present embodiment, the object in the virtual space is an object corresponding to equipment or the like in the factory. A line indicating an external shape feature of the three-dimensional CAD model Mo2 is a "ridge line" and the ridge line is projected on the image data.

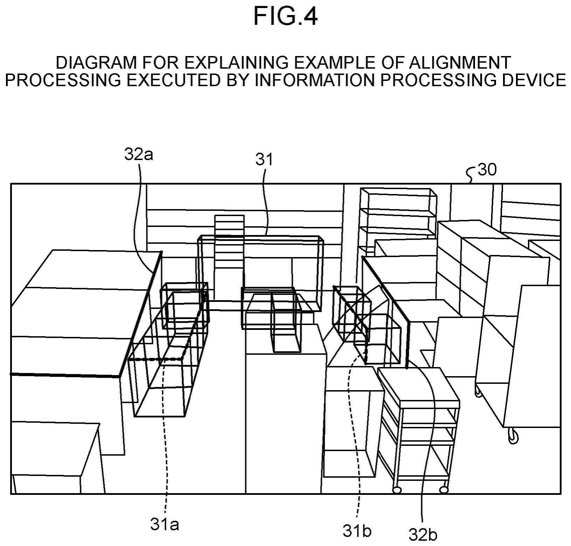

Subsequently, an example of the alignment processing illustrated in Step S107 in FIG. 2 is more specifically explained. FIG. 4 is a diagram for explaining an example of alignment processing executed by the information processing device. The information processing device 100 generates screen information 30 for presenting a method of alignment and causes a display unit to display the screen information 30. A user refers to the screen information 30 displayed on the display unit and operates an input unit to manually perform alignment.

The information processing device 100 arranges a ridge line group 31 on the image data in the screen information 30. The ridge line group 31 is a line group obtained by projecting ridge lines of the three-dimensional CAD model Mo2 onto the image data. The information processing device 100 highlights a ridge line paired with the feature line among a plurality of ridge lines included in the ridge line group 31. The pair of the feature line and the ridge line is designated in step 106.

In the example illustrated in FIG. 4, a feature line 32a and a ridge line 31a are paired and highlighted. A feature line 32b and a ridge line 31b are paired and highlighted.

A procedure of performing manual calibration is the following order of a procedure 1 to a procedure 4. A calibration target is the highlighted pair of the feature line 32a and the ridge line 31a or the highlighted pair of the feature line 32b and the ridge line 31b.
Procedure 1: Change a camera parameter R and calibrate a rotation direction
Procedure 2: Change a camera parameter f and calibrate a focal length
Procedure 3: Change a camera parameter T and perform calibration by left-right translational movement
Procedure 4: Change the camera parameter T and perform calibration by depth translational movement

By performing the calibration procedure in the order of the procedure 1 to the procedure 4 explained above, it is possible to efficiently calibrate a pair of a feature line and a ridge line without going back in the procedure. For example, a change in a group of ridge lines in the case in which the focal length is operated is very similar to a change in a ridge line group in the case in which the depth translational movement is performed, but operation for adjusting line segments of the pair to be parallel depends on the operation of the focal length. When efficiently performing calibration, it is better to perform translational movement after the focal length is determined. The information processing device 100 causes the display unit to display information for assisting operation of the user on the screen information 30 based on a relationship between the pair of the feature line and ridge line such that the user can perform calibration in the order of a procedure 1 to a procedure 4.

The information processing device 100 displays auxiliary information of the procedure 1 to the procedure 4 in order on the screen information 30 and receives superimposition (calibration) operation corresponding to the procedures. For example, the information processing device 100 displays, on a screen, auxiliary information indicating a request for superimposition operation of a rotation direction with respect to the pair of the feature line and the ridge line. When the superimposition operation of the rotation direction is completed, the information processing device 100 displays, on the screen, auxiliary information indicating a request for superimposition operation of a focal length with respect to the pair of the feature line and the ridge line after the superimposition operation of the rotation direction is executed. Subsequently, when the superimposition operation of the focal length is completed, the information processing device 100 displays, on the screen, auxiliary information indicating a request for superimposition operation of translational movement with respect to the pair of the feature line and the ridge line after the superimposition operation of the focal length is executed. The information processing device 100 sets final camera parameters after the superimposition operation of the translational movement is completed.

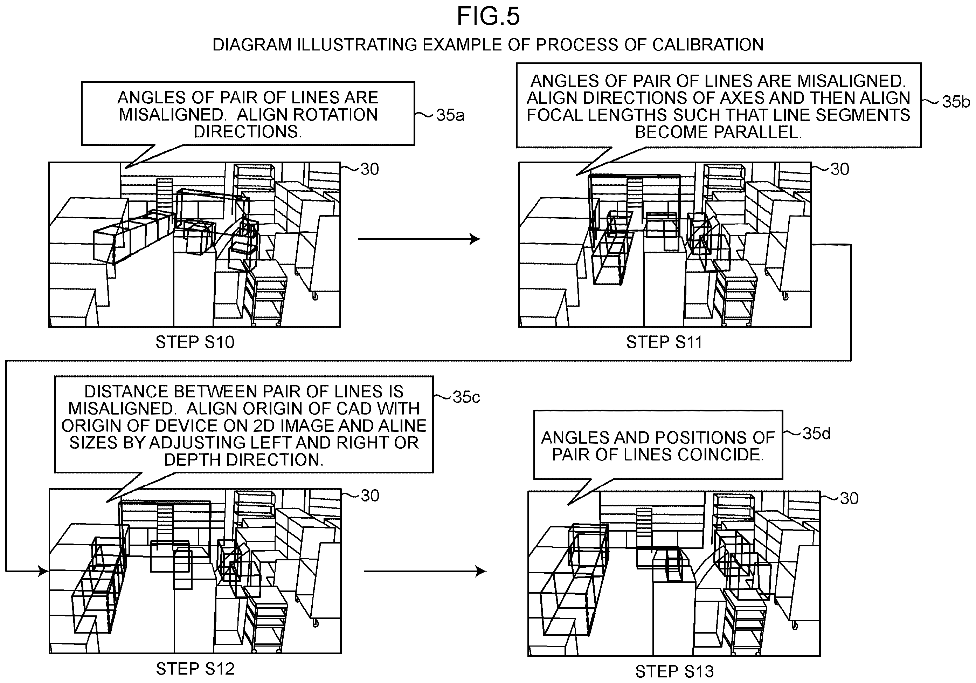

FIG. 5 is a diagram illustrating an example of a process of calibration. Although illustration of highlight display is omitted in the explanation referring to FIG. 5, it is assumed that the pair of the feature line and the ridge line are displayed on the screen information 30 in a highlighted state.

Step S10 in FIG. 5 is explained. The information processing device 100 causes the display unit to display auxiliary information 35a in order to cause the user to execute the procedure 1. For example, auxiliary information 35a includes text "The angles of the pair of the lines are misaligned. Please align the rotation directions". The user operates the input unit to calibrate the rotation direction. When receiving operation of the rotation direction of the user, the information processing device 100 changes a value of the rotation R of the camera parameters according to the operation of the rotation direction and causes the display unit to display a ridge line group on the screen information 30 according to the changed camera parameter. The information processing device 100 repeatedly executes the processing explained above every time the operation of the rotation direction is received.

Step S11 is explained. The information processing device 100 causes the display unit to display auxiliary information 35b in order to cause the user to execute the procedure 2. For example, auxiliary information 35b includes text "The angles of the pair of the lines are misaligned. Please align the directions of the axes and then align the focal lengths such that the line segments become parallel". The user operates the input unit to calibrate a focal direction. When receiving operation of the focal length by the user, the information processing device 100 changes a value of the focal length f of the camera parameters according to the operation of the focal length and causes the display unit to display a ridge line group on the screen information 30 according to the changed camera parameter.

When an angle formed by the pair of the ridge line and the feature line is less than a threshold, the information processing device 100 proceeds to processing in Step S12. The information processing device 100 may suppress operation of a translation direction until the angle between the pair of the ridge line and the feature line becomes less than the threshold. For example, when receiving the operation of the translation direction, the information processing device 100 may disable the operation of the translation direction and display the auxiliary information 35b and the like again.

Step S12 is explained. The information processing device 100 causes the display unit to display auxiliary information 35c in order to cause the user to execute the procedure 3 and the procedure 4. For example, the auxiliary information 35c includes text "The distance between the pair of the lines is misaligned. Please align the origin of the CAD with the origin of the device on the 2D image and align the size by adjusting the left and the right or the depth direction". The user operates the input unit to perform calibration by left-right translational movement and depth translational movement. When receiving operation of left-right translational movement and depth translational movement by the user, the information processing device 100 changes a value of the translation T of the camera parameters according to the operation of the left-right translational movement and the depth translational movement and causes the display unit to display a ridge line group on the screen information 30 according to the changed camera parameter.

When the distance between the pair of the ridge line and the feature line is less than the threshold, the information processing device 100 shifts to the processing in Step S13.

Step S13 is explained. The information processing device 100 displays auxiliary information 35d. The auxiliary information 35d includes text "The angles and the positions of the pair of the lines coincide". The camera parameters at the point in time of Step S13 are camera parameters finally determined by the manual calibration.

As explained in Step S10 to Step S13, the information processing device 100 sets the camera parameters based on a feature value of a position and a posture of a ridge line group that is changed by calibration of the user, the ridge line group corresponding to the three-dimensional CAD data. The information processing device 100 generates setting information in which the set camera parameters and the camera identification information are associated with each other. Accordingly, the setting information can be appropriately set and, by using the setting information, an object present in the physical space can be appropriately expressed in the virtual space using the digital twin.

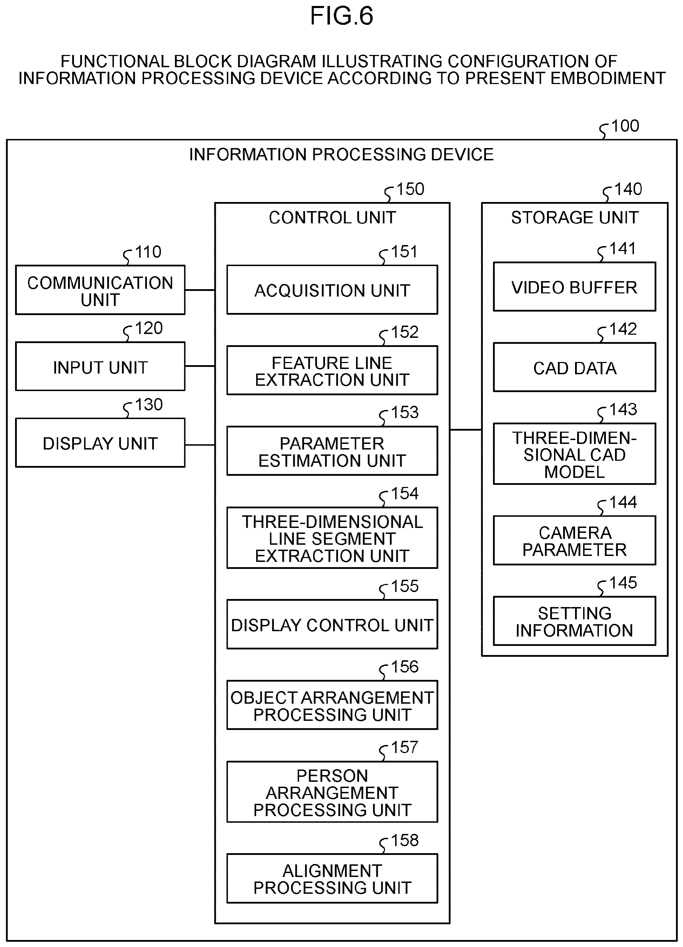

Subsequently, a configuration example of the information processing device 100 that executes the processing explained above is explained. FIG. 6 is a functional block diagram illustrating a configuration of the information processing device according to the present embodiment. As illustrated in FIG. 6, the information processing device 100 includes a communication unit 110, an input unit 120, a display unit 130, a storage unit 140, and a control unit 150.

The communication unit 110 executes data communication with the camera 10, an external device, and the like via a network. The communication unit 110 is a Network Interface Card (NIC) or the like. For example, the communication unit 110 receives image data from the camera 10.

The input unit 120 is an input device that inputs various kinds of information to the control unit 150 of the information processing device 100. For example, the input unit 120 corresponds to a keyboard, a mouse, a touch panel, or the like. The user operates the input unit 120 to perform various kinds of operation concerning calibration of feature lines and ridge lines explained with reference to FIG. 5.

The display unit 130 is a display device that displays information output from the control unit 150. For example, the display unit 130 displays the screen information 30 illustrated in FIG. 4 and FIG. 5.

The storage unit 140 includes a video buffer 141, CAD data 142, a three-dimensional CAD model 143, camera parameters 144, and setting information 145. The storage unit 140 is a storage device such as a memory.

The video buffer 141 retains image data captured by the camera 10. For example, the video buffer 141 retains image data in association with the camera identification information.

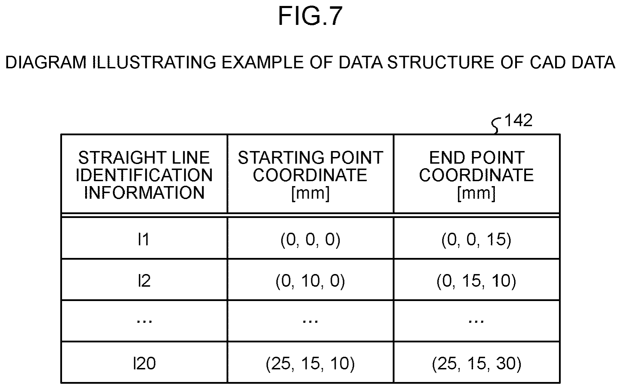

The CAD data 142 is model information representing the three-dimensional CAD model 143 of a three-dimensional structure. FIG. 7 is a diagram illustrating an example of a data structure of CAD data. As illustrated in FIG. 7, the CAD data 142 associates straight line identification information, a start point coordinate, and an end point coordinate. The straight line identification information is information for identifying a straight line (a side) of the three-dimensional CAD model 143. The start point coordinate is a three-dimensional coordinate of a start point of the straight line identified by the straight line identification information. The end point coordinate is a three-dimensional coordinate of an end point of the straight line identified by the straight line identification information.

The three-dimensional CAD model 143 is a model generated based on the CAD data 142. For example, the three-dimensional CAD model 143 corresponds to the three-dimensional CAD model Mo2 explained with reference to FIG. 3.

The camera parameters 144 include the focal length f, the rotation R, and the translation T with respect to external parameters and internal parameters of the camera 10. Initial values of the camera parameter 144 are calculated in Step S105 in FIG. 2. The camera parameters 144 are updated by the alignment processing explained in Step S107 in FIG. 2.

The setting information 145 includes camera parameters of cameras. For example, the setting information 145 retains information in which the camera identification information and the camera parameters are associated with each other.

The control unit 150 includes an acquisition unit 151, a feature line extraction unit 152, a parameter estimation unit 153, a three-dimensional line segment extraction unit 154, a display control unit 155, an object arrangement processing unit 156, a person arrangement processing unit 157, and an alignment processing unit 158. The control unit 150 is a Central Processing Unit (CPU), a Graphics Processing Unit (GPU), or the like.

The acquisition unit 151 acquires image data from the camera 10. Camera identification information of the camera 10 that has captured the image data is set in the image data. The acquisition unit 151 stores the image data in the video buffer 141 in association with the camera identification information.

The feature line extraction unit 152 acquires the image data from the video buffer and extracts a feature line included in the image data. The feature line is a two-dimensional edge line of the image data. For example, the feature line extraction unit 152 may extract a feature line based on a technique described in a related art document "R.G.von Gioi et al., LSD: a Line Segment Detector, IPOL, 2, (2012)".

The feature line extraction unit 152 outputs an extraction result of the feature line to the parameter estimation unit 153 and the display control unit 155.

The parameter estimation unit 153 specifies a vanishing point based on the extraction result of the feature line and estimates camera parameters based on the vanishing point. For example, the parameter estimation unit 153 may estimate the camera parameters based on a technique described in a related art document "R. Orghidan et al., Camera calibration using two or three vanishing points, In Proc. Of the Federated Conference on Computer Science and Information Systems pp. 123-130.".

The parameter estimation unit 153 registers the camera parameters 144 serving as an estimation result in the storage unit 140. Note that the parameter estimation unit 153 may set standard values prepared in advance for the rotation R and the translation T among the focal length f, the rotation R, and the translation T included in the camera parameter 144 and estimate only the focal length f using the vanishing point.

The three-dimensional line segment extraction unit 154 generates the three-dimensional CAD model 143 based on the CAD data 142 and extracts a plurality of ridge lines from the three-dimensional CAD model 143. The ridge lines are three-dimensional lines indicating an external shape feature of the three-dimensional CAD model 143. The three-dimensional line segment extraction unit 154 outputs information concerning the ridge lines to the display control unit 155.

The display control unit 155 acquires the image data from the video buffer 141 and generates screen information by projecting the plurality of ridge lines onto the image data based on the camera parameters 144. The screen information generated by the display control unit 155 is the screen information illustrated in FIG. 5.

The display control unit 155 executes the alignment processing described with reference to FIG. 5 to cause the user to perform the calibration of the procedure 1 to the procedure 4 and updates the camera parameters 144. It is assumed that a set of the pair of the ridge line and the feature line is set in advance. For example, the display control unit 155 displays feature lines of the object extracted from the image data and ridge lines of the three-dimensional CAD model 143 in a selectable state and receives a selection instruction indicating a pair of a feature line and a ridge line that are targets to be superimposed.

When the alignment processing is completed, the display control unit 155 registers the camera identification information of the camera 10 corresponding to the alignment processing and the camera parameters 144 in association with each other in the setting information 145. When a plurality of cameras are present, the display control unit 155 repeatedly executes the processing explained above for each of the cameras and registers the camera identification information and the camera parameters 144 in the setting information 145 in association with each other.

The object arrangement processing unit 156 performs processing of arranging, in the virtual space, an object in the physical space included in the image data. For example, the object arrangement processing unit 156 acquires image data captured by the camera 10 and inputs the image data to a first machine learning model to extract a region of the object included in the image data. The first machine learning model is a Neural Network (NN) to which the image data is input and from which the region of the object is output. The first machine learning model is a trained machine learning model.

The object arrangement processing unit 156 acquires camera parameters corresponding to the camera identification information of the camera 10 from the setting information 145. The object arrangement processing unit 156 specifies, based on the acquired camera parameter, a position on the virtual space corresponding to the position of the object on the image data. The object arrangement processing unit 156 arranges, at the specified position on the virtual space, a three-dimensional object corresponding to the object on the image data.

For example, the object arrangement processing unit 156 generates a three-dimensional object by inputting an image of the region of the object included in the image data to a second machine learning model. The second machine learning model is an NN to which the image data of the region of the object is input and from which the three-dimensional object is output. The second machine learning model is a trained machine learning model.

The object arrangement processing unit 156 arranges, in the virtual space, the object in the physical space included in the image data by executing the processing explained above also on image data captured by a camera other than the camera 10.

The person arrangement processing unit 157 performs processing of arranging, the virtual space, as an avatar, a person in the physical space included in the image data. For example, the person arrangement processing unit 157 acquires the image data captured by the camera 10 and inputs the image data to a third machine learning model to extract a region of the person included in the image data. The third machine learning model is a Neural Network (NN) to which the image data is input and from which the region of the person is output. The third machine learning model is a trained machine learning model.

The person arrangement processing unit 157 generates skeleton information of the person by inputting the image of the region of the person to a fourth machine learning model. The skeleton information is information in which two-dimensional or three-dimensional coordinates are set for a plurality of joints defined in a human body model. In the present embodiment, it is assumed that two-dimensional coordinates are set for the plurality of joints in the skeleton information.

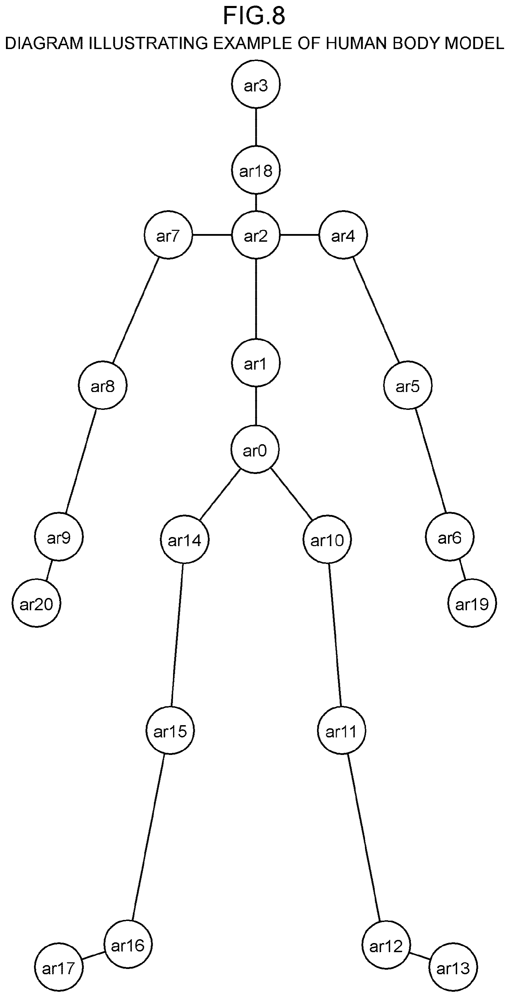

FIG. 8 is a diagram for explaining an example of the human body model. As illustrated in FIG. 8, the human body model is defined by twenty-one joints ar0 to ar20.

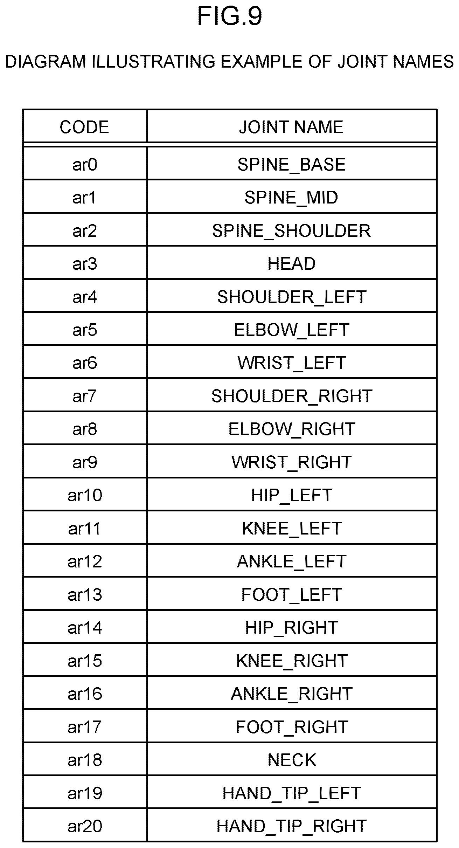

A relationship between the joints ar0 to ar20 illustrated in FIG. 8 and joint names is as illustrated in FIG. 9. FIG. 9 is a diagram illustrating an example of the joint names. For example, a joint name of the joint ar0 is "SPINE_BASE". Joint names of the joints ar1 to a20 are as illustrated in FIG. 9 and explanation of the joint names is omitted.

The fourth machine learning model is an NN to which the image data of the region of the person is input and the skeleton information is output. The fourth machine learning model is a trained machine learning model.

The person arrangement processing unit 157 acquires camera parameters corresponding to the camera identification information of the camera 10 from the setting information 145. The person arrangement processing unit 157 specifies, based on the acquired camera parameters, parts on the virtual space with respect to the positions of the joints of the skeleton information on the image data. The person arrangement processing unit 157 arranges, at the specified positions on the virtual space, a three-dimensional avatar corresponding to the person on the image data. When arranging the avatar, the person arrangement processing unit 157 arranges the avatar with the positions of the joints aligned with the positions of the joints on the virtual space.

For example, the person arrangement processing unit 157 generates a three-dimensional avatar by inputting the image of the region of the person included in the image data and the skeleton information to a fifth machine learning model. The fifth machine learning model is an NN in which the image data of the region of the person and the skeleton information are input and from which the three-dimensional avatar is output. The fifth machine learning model is a trained machine learning model.

Here, the case in which the person arrangement processing unit 157 generates the three-dimensional avatar using the fifth machine learning model is explained. However, a three-dimensional avatar prepared in advance may be used.

The alignment processing unit 158 performs processing of assisting the manual alignment performed by the user explained with reference to FIG. 4 and FIG. 5. The alignment processing unit 158 calculates an error between a pair of a feature line and a ridge line. The alignment processing unit 158 updates the camera parameters 144 such that the error decreases. For example, the user operates the input unit 120 to input an automatic alignment request.

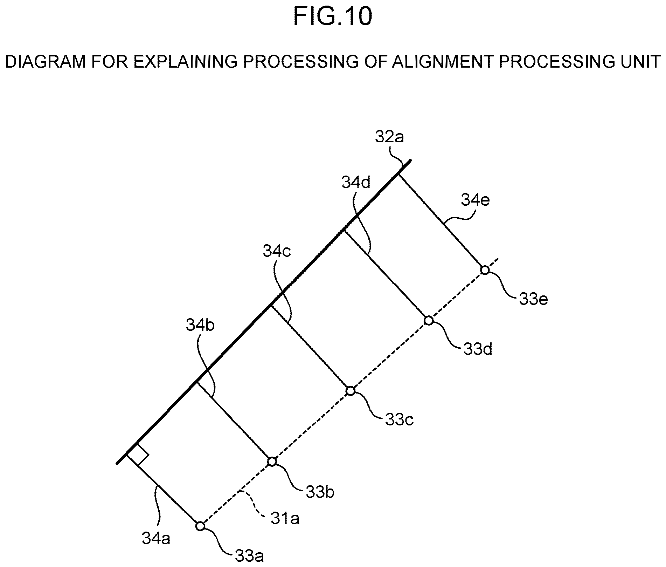

FIG. 10 is a diagram for explaining processing of the alignment processing unit. Here, the explanation is made using a feature line 32c on the image data and a ridge line 31c projected on the screen data based on the camera parameters 144. The alignment processing unit 158 sets a plurality of sample points 33a, 33b, 33c, 33d, and 33e at equal intervals on the ridge line 31c.

The alignment processing unit 158 sets perpendicular lines 34a, 34b, 34c, 34d, and 34e with respect to the feature line 32a from the sample points 33a to 33e. The alignment processing unit 158 calculates a sum of the lengths (errors) of the perpendicular lines 34a to 34e. The alignment processing unit 158 corrects f, R, and T of the camera parameters 144 such that the calculated sum of the errors decreases. For example, the alignment processing unit 158 corrects f, R, and T of the camera parameters 144 using the Levenberg-Marquardt method such that the sum of the lengths (errors) of the perpendicular lines 34a to 34e is minimized. The alignment processing unit 158 repeatedly executes the processing explained above until the sum of the lengths (errors) of the perpendicular lines 34a to 34e becomes less than a predetermined value.

The alignment processing unit 158 may execute the processing described in "R. Hartley and A. Zisserman. Multiple View Geometry In Computer Vision. Cambridge University Press, second edition, 2003." as the Levenberg-Marquardt method.

Subsequently, effects of the information processing device 100 according to the present embodiment are explained. The information processing device 100 sets the camera parameters 144 based on a feature value of a position and a posture of a ridge line group that is changed by calibration of the user, the ridge line group corresponding to the three-dimensional CAD data. The information processing device 100 generates setting information 145 in which the set camera parameters 144 and the camera identification information are associated with each other. Accordingly, the setting information 145 can be appropriately set and, by using such setting information, an object present in the physical space can be appropriately expressed in the virtual space using the digital twin.

The information processing device 100 displays feature lines of the object extracted from the image data and ridge lines of the three-dimensional CAD model 143 in a selectable state and receives a selection instruction indicating a pair of a feature line and a ridge line that are targets to be superimposed. After superimposition operation for the pair of the feature line and the ridge line is executed, the information processing device 100 updates the camera parameters 144 based on an angle or a distance between the feature line and the ridge line that are the targets to be superimposed. Accordingly, the camera parameters 144 of the camera 10 can be accurately specified.

The information processing device 100 displays an instruction to request operation of a rotation direction or a focal length for the feature line and the ridge line. When the angle formed by the feature line and the ridge line becomes less than a threshold according to the operation of the rotation direction or the focal length, the information processing device 100 displays an instruction to request the operation of the translational movement for the feature line and the ridge line. Accordingly, it is possible to cause the user to perform screen operation in a correct procedure.

The information processing device 100 calculates an error between the feature line and the ridge line and superimposes the feature line and the ridge line such that the error decreases. Accordingly, it is possible to reduce a load on the user who performs alignment. The accuracy of the calibration can be improved as compared with the manual calibration and the accuracy of the camera parameter 144 can be improved.

The information processing device 100 performs, based on the setting information 145, processing of arranging, in the virtual space, the object in the physical space included in the image data. The information processing device 100 performs, based on the setting information 145, processing of arranging, in the virtual space, the person in the physical space included in the image data. Accordingly, the object and the person in the physical space can be reproduced on the virtual space.

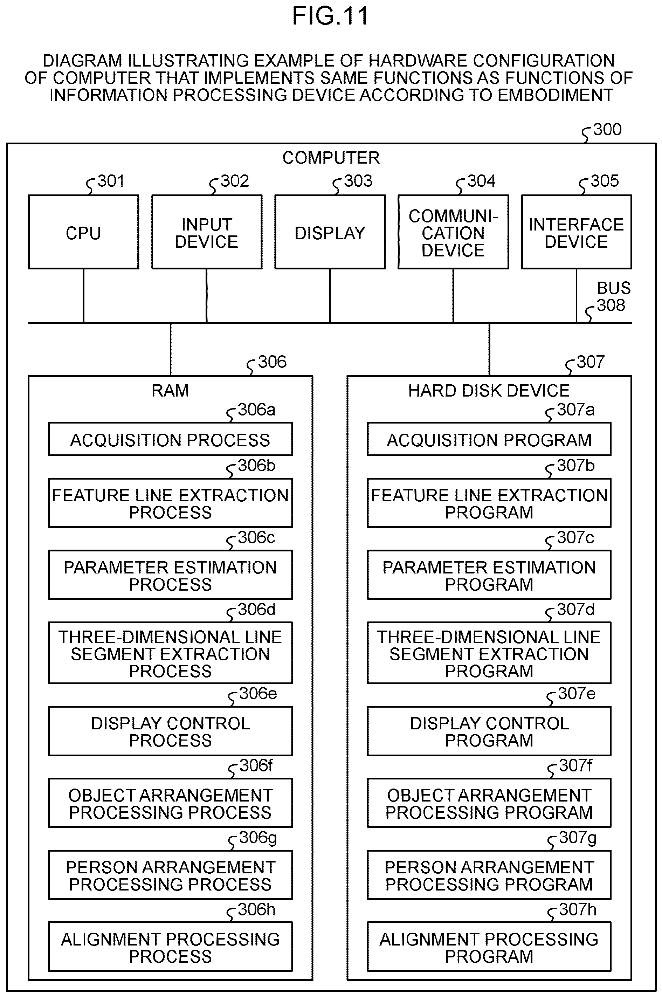

Subsequently, an example of a hardware configuration of a computer that implements the same functions as the functions of the information processing device 100 explained above is explained. FIG. 11 is a diagram illustrating an example of a hardware configuration of a computer that implements the same functions as the functions of the information processing device according to the embodiment.

As illustrated in FIG. 11, a computer 300 includes a CPU 301 that executes various kinds of arithmetic processing, an input device 302 that receives input of data from a user, and a display 303. The computer 300 includes a communication device 304 that exchanges data with an external device or the like via a wired or wireless network and an interface device 305. The computer 300 includes a RAM 306 that temporarily stores various kinds of information and a hard disk device 307. The devices 301 to 307 are connected to a bus 308.

The hard disk device 307 includes an acquisition program 307a, a feature line extraction program 307b, a parameter estimation program 307c, and a three-dimensional line segment extraction program 307d. The hard disk device 307 includes a display control program 307e, an object arrangement processing program 307f, a person arrangement processing program 307g, and an alignment processing program 307h. The CPU 301 reads the programs 307a to 307h and loads the programs in the RAM 306.

The acquisition program 307a functions as an acquisition process 306a. The feature line extraction program 307b functions as a feature line extraction process 306b. The parameter estimation program 307c functions as a parameter estimation process 306c. The three-dimensional line segment extraction program 307d functions as a three-dimensional line segment extraction process 306d. The display control program 307e functions as a display control process 306e. The object arrangement processing program 307f functions as an object arrangement processing process 306f. The person arrangement processing program 307g functions as a person arrangement processing process 306g. The alignment processing program 307h functions as an alignment processing process 306h.

Processing of the acquisition process 306a corresponds to the processing of the acquisition unit 151. Processing of the feature line extraction process 306b corresponds to the processing of the feature line extraction unit 152. Processing of the parameter estimation process 306c corresponds to the processing of the parameter estimation unit 153. Processing of the three-dimensional line segment extraction process 306d corresponds to the processing of the three-dimensional line segment extraction unit 154. Processing of the display control process 306e corresponds to the processing of the display control unit 155. Processing of the object arrangement processing process 306f corresponds to the processing of the object arrangement processing unit 156. Processing of the person arrangement processing process 306g corresponds to the processing of the person arrangement processing unit 157. Processing of the alignment processing process 306h corresponds to the processing of the alignment processing unit 158.

The programs 307a to 307h do not always have to be stored in the hard disk device 307 from the beginning. For example, the programs are stored in a "portable physical medium" such as a flexible disk (FD), a CD-ROM, a DVD, a magnetooptical disk, or an IC card inserted into the computer 300. The computer 300 may read and execute the programs 307a to 307h.

Concerning embodiments including the examples explained above, the following supplementary notes are further disclosed.

(Supplementary note 1) A setting program for causing a computer to execute processing of:
acquiring a two-dimensional video in which an object is arranged in a physical space, the two-dimensional video being captured by a camera device;
acquiring three-dimensional design data defining formation of the object in a virtual space;
displaying, on a screen, in a selectable state, first edge lines of the object extracted from a captured image included in the two-dimensional video and second edge lines of the object in the three-dimensional design data;
receiving a selection instruction indicating a pair of the first edge line and the second edge line that are targets to be superimposed; and
setting camera parameters of the camera device based on superimposition operation for the pair of the first edge line and the second edge line.

(Supplementary note 2) The setting program according to the supplementary note 1, wherein, in the processing of setting the camera parameters, after the superimposition operation for the pair of the first edge line and the second edge line is executed, the camera parameters of the camera device are set based on an angle or a distance between the first edge line and the second edge line that are the targets to be superimposed.

(Supplementary note 3) The setting program according to the supplementary note 1, further causing the computer to execute processing of displaying an instruction to request operation of a rotation direction or a focal length for the first edge line and the second edge line and displaying an instruction to request operation of translational movement for the first edge line and the second edge line when an angle formed by the first edge line and the second edge line becomes less than a threshold according to the operation of the rotation direction or the focal length.

(Supplementary note 4) The setting program according to the supplementary note 1, further causing the computer to execute processing of calculating an error between the first edge line and the second edge line and superimposing the first edge line and the second edge line to reduce the error.

(Supplementary note 5) The setting program according to the supplementary note 1, further causing the computer to execute processing of:
displaying, on the screen, auxiliary information indicating a request for superimposition operation for a rotation direction for the pair of the first edge line and the second edge line;
when the superimposition operation for the rotation direction is completed, displaying, on the screen, auxiliary information indicating a request for superimposition operation for a focal length for the pair of the first edge line and the second edge line after the superimposition operation for the rotation direction is executed; and
when the superimposition operation for the focal length is completed, displaying, on the screen, auxiliary information indicating a request for superimposition operation for translational movement for the pair after the superimposition operation for the focal length is executed, wherein
in the processing of setting the camera parameters, the camera parameters of the camera device are set after the superimposition operation for the translational movement is completed.

(Supplementary note 6) The setting program according to the supplementary note 1, further causing the computer to execute processing of specifying, based on the camera parameters, a correspondence relationship between the physical space and the virtual space in digital twin.

(Supplementary note 7) A setting method including a computer executing processing of:
acquiring a two-dimensional video in which an object is arranged in a physical space, the two-dimensional video being captured by a camera device;
acquiring three-dimensional design data defining formation of the object in a virtual space;
displaying, on a screen, in a selectable state, first edge lines of the object extracted from a captured image included in the two-dimensional video and second edge lines of the object in the three-dimensional design data;
receiving a selection instruction indicating a pair of the first edge line and the second edge line that are targets to be superimposed; and
setting camera parameters of the camera device based on superimposition operation for the pair of the first edge line and the second edge line.

(Supplementary note 8) The setting method according to the supplementary note 7, wherein, in the processing of setting the camera parameters, after the superimposition operation for the pair of the first edge line and the second edge line is executed, the camera parameters of the camera device are set based on an angle or a distance between the first edge line and the second edge line that are the targets to be superimposed.

(Supplementary note 9) The setting method according to the supplementary note 7, further including the computer executing processing of displaying an instruction to request operation of a rotation direction or a focal length for the first edge line and the second edge line and displaying an instruction to request operation of translational movement for the first edge line and the second edge line when an angle formed by the first edge line and the second edge line becomes less than a threshold according to the operation of the rotation direction or the focal length.

(Supplementary note 10) The setting method according to the supplementary note 7, further including the computer executing processing of calculating an error between the first edge line and the second edge line and superimposing the first edge line and the second edge line to reduce the error.

(Supplementary note 11) The setting method according to the supplementary note 7, further including the computer executing processing of:
displaying, on the screen, auxiliary information indicating a request for superimposition operation for a rotation direction for the pair of the first edge line and the second edge line;
when the superimposition operation for the rotation direction is completed, displaying, on the screen, auxiliary information indicating a request for superimposition operation for a focal length for the pair of the first edge line and the second edge line after the superimposition operation for the rotation direction is executed; and
when the superimposition operation for the focal length is completed, displaying, on the screen, auxiliary information indicating a request for superimposition operation for translational movement for the pair after the superimposition operation for the focal length is executed, wherein
in the processing of setting the camera parameters, the camera parameters of the camera device are set after the superimposition operation for the translational movement is completed.

(Supplementary note 12) The setting method according to the supplementary note 7, further including the computer executing processing of specifying, based on the camera parameters, a correspondence relationship between the physical space and the virtual space in digital twin.

(Supplementary note 13) An information processing device including a control unit that executes processing of:
acquiring a two-dimensional video in which an object is arranged in a physical space, the two-dimensional video being captured by a camera device;
acquiring three-dimensional design data defining formation of the object in a virtual space;
displaying, on a screen, in a selectable state, first edge lines of the object extracted from a captured image included in the two-dimensional video and second edge lines of the object in the three-dimensional design data;
receiving a selection instruction indicating a pair of the first edge line and the second edge line that are targets to be superimposed; and
setting camera parameters of the camera device based on superimposition operation for the pair of the first edge line and the second edge line.

(Supplementary note 14) The information processing device according to the supplementary note 13, wherein, in the processing of setting the camera parameters, after the superimposition operation for the pair of the first edge line and the second edge line is executed, the camera parameters of the camera device are set based on an angle or a distance between the first edge line and the second edge line that are the targets to be superimposed.

(Supplementary note 15) The information processing device according to the supplementary note 13, wherein the control unit further executes processing of displaying an instruction to request operation of a rotation direction or a focal length for the first edge line and the second edge line and displaying an instruction to request operation of translational movement for the first edge line and the second edge line when an angle formed by the first edge line and the second edge line becomes less than a threshold according to the operation of the rotation direction or the focal length.

(Supplementary note 16) The information processing device according to the supplementary note 13, wherein the control unit further executes processing of calculating an error between the first edge line and the second edge line and superimposing the first edge line and the second edge line to reduce the error.

(Supplementary note 17) The information processing device according to the supplementary note 13, wherein the control unit further executes processing of:
displaying, on the screen, auxiliary information indicating a request for superimposition operation for a rotation direction for the pair of the first edge line and the second edge line;
when the superimposition operation for the rotation direction is completed, displaying, on the screen, auxiliary information indicating a request for superimposition operation for a focal length for the pair of the first edge line and the second edge line after the superimposition operation for the rotation direction is executed; and
when the superimposition operation for the focal length is completed, displaying, on the screen, auxiliary information indicating a request for superimposition operation for translational movement for the pair after the superimposition operation for the focal length is executed, wherein
in the processing of setting the camera parameters, the camera parameters of the camera device are set after the superimposition operation for the translational movement is completed.

(Supplementary note 18) The information processing device according to the supplementary note 13, wherein the control unit further executes processing of specifying, based on the camera parameters, a correspondence relationship between the physical space and the virtual space in digital twin.

### Explanation of Reference

- 100: INFORMATION PROCESSING DEVICE
- 110: COMMUNICATION UNIT
- 120: INPUT UNIT
- 130: DISPLAY UNIT
- 140: STORAGE UNIT
- 141: VIDEO BUFFER
- 142: CAD DATA
- 143: THREE-DIMENSIONAL CAD MODEL
- 144: CAMERA PARAMETER
- 145: SETTING INFORMATION
- 150: CONTROL UNIT
- 151: ACQUISITION UNIT
- 152: FEATURE LINE EXTRACTION UNIT
- 153: PARAMETER ESTIMATION UNIT
- 154: THREE-DIMENSIONAL LINE SEGMENT EXTRACTION UNIT
- 155: DISPLAY CONTROL UNIT
- 156: OBJECT ARRANGEMENT PROCESSING UNIT
- 157: PERSON ARRANGEMENT PROCESSING UNIT
- 158: ALIGNMENT PROCESSING UNIT

## Claims

1. A setting program for causing a computer to execute processing of:
acquiring a two-dimensional video in which an object is arranged in a physical space, the two-dimensional video being captured by a camera device;
acquiring three-dimensional design data defining formation of the object in a virtual space;
displaying, on a screen, in a selectable state, first edge lines of the object extracted from a captured image included in the two-dimensional video and second edge lines of the object in the three-dimensional design data;
receiving a selection instruction indicating a pair of the first edge line and the second edge line that are targets to be superimposed; and
setting camera parameters of the camera device based on superimposition operation for the pair of the first edge line and the second edge line.

2. The setting program according to claim 1, wherein, in the processing of setting the camera parameters, after the superimposition operation for the pair of the first edge line and the second edge line is executed, the camera parameters of the camera device are set based on an angle or a distance between the first edge line and the second edge line that are the targets to be superimposed.

3. The setting program according to claim 1, further causing the computer to execute processing of displaying an instruction to request operation of a rotation direction or a focal length for the first edge line and the second edge line and displaying an instruction to request operation of translational movement for the first edge line and the second edge line when an angle formed by the first edge line and the second edge line becomes less than a threshold according to the operation of the rotation direction or the focal length.

4. The setting program according to claim 1, further causing the computer to execute processing of calculating an error between the first edge line and the second edge line and superimposing the first edge line and the second edge line to reduce the error.

5. The setting program according to claim 1, further causing the computer to execute processing of:
displaying, on the screen, auxiliary information indicating a request for superimposition operation for a rotation direction for the pair of the first edge line and the second edge line;
when the superimposition operation for the rotation direction is completed, displaying, on the screen, auxiliary information indicating a request for superimposition operation for a focal length for the pair of the first edge line and the second edge line after the superimposition operation for the rotation direction is executed; and
when the superimposition operation for the focal length is completed, displaying, on the screen, auxiliary information indicating a request for superimposition operation for translational movement for the pair after the superimposition operation for the focal length is executed, wherein
in the processing of setting the camera parameters, the camera parameters of the camera device are set after the superimposition operation for the translational movement is completed.

6. The setting program according to claim 1, further causing the computer to execute processing of specifying, based on the camera parameters, a correspondence relationship between the physical space and the virtual space in digital twin.

7. A setting method comprising a computer executing processing of:
acquiring a two-dimensional video in which an object is arranged in a physical space, the two-dimensional video being captured by a camera device;
acquiring three-dimensional design data defining formation of the object in a virtual space;
displaying, on a screen, in a selectable state, first edge lines of the object extracted from a captured image included in the two-dimensional video and second edge lines of the object in the three-dimensional design data;
receiving a selection instruction indicating a pair of the first edge line and the second edge line that are targets to be superimposed; and
setting camera parameters of the camera device based on superimposition operation for the pair of the first edge line and the second edge line.

8. The setting method according to claim 7, wherein, in the processing of setting the camera parameters, after the superimposition operation for the pair of the first edge line and the second edge line is executed, the camera parameters of the camera device are set based on an angle or a distance between the first edge line and the second edge line that are the targets to be superimposed.

9. The setting method according to claim 7, further comprising the computer executing processing of displaying an instruction to request operation of a rotation direction or a focal length for the first edge line and the second edge line and displaying an instruction to request operation of translational movement for the first edge line and the second edge line when an angle formed by the first edge line and the second edge line becomes less than a threshold according to the operation of the rotation direction or the focal length.

10. The setting method according to claim 7, further comprising the computer executing processing of calculating an error between the first edge line and the second edge line and superimposing the first edge line and the second edge line to reduce the error.

11. The setting method according to claim 7, further comprising the computer executing processing of:
displaying, on the screen, auxiliary information indicating a request for superimposition operation for a rotation direction for the pair of the first edge line and the second edge line;
when the superimposition operation for the rotation direction is completed, displaying, on the screen, auxiliary information indicating a request for superimposition operation for a focal length for the pair of the first edge line and the second edge line after the superimposition operation for the rotation direction is executed; and
when the superimposition operation for the focal length is completed, displaying, on the screen, auxiliary information indicating a request for superimposition operation for translational movement for the pair after the superimposition operation for the focal length is executed, wherein
in the processing of setting the camera parameters, the camera parameters of the camera device are set after the superimposition operation for the translational movement is completed.

12. The setting method according to claim 7, further comprising the computer executing processing of specifying, based on the camera parameters, a correspondence relationship between the physical space and the virtual space in digital twin.

13. An information processing device comprising a control unit that executes processing of:
acquiring a two-dimensional video in which an object is arranged in a physical space, the two-dimensional video being captured by a camera device;
acquiring three-dimensional design data defining formation of the object in a virtual space;
displaying, on a screen, in a selectable state, first edge lines of the object extracted from a captured image included in the two-dimensional video and second edge lines of the object in the three-dimensional design data;
receiving a selection instruction indicating a pair of the first edge line and the second edge line that are targets to be superimposed; and
setting camera parameters of the camera device based on superimposition operation for the pair of the first edge line and the second edge line.

14. The information processing device according to claim 13, wherein, in the processing of setting the camera parameters, after the superimposition operation for the pair of the first edge line and the second edge line is executed, the camera parameters of the camera device are set based on an angle or a distance between the first edge line and the second edge line that are the targets to be superimposed.

15. The information processing device according to claim 13, wherein the control unit further executes processing of displaying an instruction to request operation of a rotation direction or a focal length for the first edge line and the second edge line and displaying an instruction to request operation of translational movement for the first edge line and the second edge line when an angle formed by the first edge line and the second edge line becomes less than a threshold according to the operation of the rotation direction or the focal length.

16. The information processing device according to claim 13, wherein the control unit further executes processing of calculating an error between the first edge line and the second edge line and superimposing the first edge line and the second edge line to reduce the error.

17. The information processing device according to claim 13, wherein the control unit further executes processing of:
displaying, on the screen, auxiliary information indicating a request for superimposition operation for a rotation direction for the pair of the first edge line and the second edge line;
when the superimposition operation for the rotation direction is completed, displaying, on the screen, auxiliary information indicating a request for superimposition operation for a focal length for the pair of the first edge line and the second edge line after the superimposition operation for the rotation direction is executed; and
when the superimposition operation for the focal length is completed, displaying, on the screen, auxiliary information indicating a request for superimposition operation for translational movement for the pair after the superimposition operation for the focal length is executed, wherein
in the processing of setting the camera parameters, the camera parameters of the camera device are set after the superimposition operation for the translational movement is completed.

18. The information processing device according to claim 13, wherein the control unit further executes processing of specifying, based on the camera parameters, a correspondence relationship between the physical space and the virtual space in digital twin.
